# NEUE EUROPÄISCHE PATENTSCHRIFT

(11) **EP 3 460 241 B2**
(45) Veröffentlichungstag und Bekanntmachung des Hinweises auf die Entscheidung über den Einspruch: **04.06.2025**
(45) Hinweis auf die Patenterteilung: 16.03.2022
(21) Anmeldenummer: 18000552.2
(22) Anmeldetag: 22.06.2018
(51) Int. Cl.: F04B 13/00, F04B 35/04, F04B 49/06

(54) **VERFAHREN ZUR ÜBERWACHUNG EINER MAGNETKOLBENPUMPE**
METHOD FOR MONITORING A MAGNETIC PISTON PUMP
PROCÉDÉ DE SURVEILLANCE D'UNE POMPE À PISTON MAGNÉTIQUE

(30) Priorität: 26.09.2017 DE 102017008988
(43) Veröffentlichungstag der Anmeldung: 27.03.2019
(73) Patentinhaber: Albonair GmbH, 44263 Dortmund (DE)
(72) Erfinder: Schrey, Ekkehard, 46145 Oberhausen (DE); Musiolik, Tobias, 45966 Gladbeck (DE); Overhoff, Werner, 45772 Marl (DE)
(74) Vertreter: Patentanwaltskanzlei Methling

(56) Entgegenhaltungen:
- EP-A1- 2 072 820
- DE-A1- 102011 088 699
- DE-A1- 102011 088 701
- DE-A1- 102013 200 540

## Beschreibung

Die Erfindung betrifft ein Verfahren zur Überwachung des Betriebs einer Magnetkolbenpumpe, bei der ein Kolben eine Hubbewegung mit einem Bewegungsbeginn und einem Bewegungsende ausführt, wobei die
Hubbewegung von einem an dem Kolben angeordneten Magnetanker mittels eines elektromagnetischen Felds veranlasst wird, das von einer Bestromung zumindest einer Spule mit einem Spulenstrom erzeugt wird, wobei die Bestromung einen Einschaltzeitpunkt und einen Ausschaltzeitpunkt aufweist.

Derartige Verfahren sind aus dem Stand der Technik bekannt. Nachteilig bei den bekannten Verfahren ist, dass sie einen großen Rechenaufwand erfordern, um die für eine Betriebsüberwachung erforderlichen Daten bereitzustellen, ohne dabei verlässliche Daten zu liefern.

Aus Dokument DE 10 2013 200 540 A1 ist ein Verfahren zur Erkennung eines Bewegungsbeginns eines elektromechanischen Aktuators einer Magnetpumpe mit einer Magnetspule bekannt, wobei der Bewegungsbeginn mittels Auswertung eines Magnetspulenstroms und dessen zeitliche Ableitungen ermittelt und anhand von Tabellenwerten oder Kennlinien in Abhängigkeit von weiteren Kenngrößen mit dem ermittelten Bewegungsbeginn ein Druck bestimmt wird, wobei zur Bestimmung des Bewegungsbeginns eine relative Induktivität aus einem zeitlichen Induktivitätsverlauf bestimmt und ein zeitlicher Verlauf der relativen Induktivität ausgewertet wird.

Aus der EP 2 072 820 A1 ist ein Verfahren zum Analysieren des Betriebs einer Dosierpumpe mit einem Kolben bekannt, bei dem ein Startzeitpunkt der Kolbenbewegung als erste Analysegröße oder/und ein Endzeitpunkt der Kolbenbewegung als zweite Analysegröße ermittelt werden und wenigstens eine Analysegröße mit einer dieser zugeordneten Referenz verglichen und beruhend auf dem Vergleichsergebnis ein Vorliegen eines Fehlerzustandes erkannt wird, wenn die Analysegröße von der Referenz abweicht, wobei die erste Analysegröße durch Bilden der ersten zeitlichen Ableitung des in einem Erregungszeitintervall fließenden elektrischen Stroms und Vergleichen derselben mit einer zugeordneten ersten Schwelle ermittelt wird und wobei die zweite Analysegröße durch Bilden der zweiten zeitlichen Ableitung des in einem Erregungszeitintervall fließenden elektrischen Stroms und Vergleichen derselben mit einer zugeordneten zweiten Schwelle ermittelt wird.

Aus Dokument DE 10 2011 088 701 A1 ist ein Verfahren zur Überwachung der Ankerbewegung einer Hubkolbenmagnetpumpe bekannt, wobei der Pumpenstromverlauf über die Zeit gemessen wird und ein Ende der Ankerbewegung in Hubrichtung erkannt wird, wenn der Pumpenstromverlauf ein lokales Minimum erreicht.

Aus der DE 10 2011 088 699 A1 ist ein Verfahren zum Steuern einer elektrischen Hubkolbenpumpe bekannt, wobei die Position des Hubkolbens der Hubkolbenpumpe aus der Änderung des Pumpenstromverlaufs ermittelt wird.

Magnetkolbenpumpen können insbesondere als Teil von Dosiersystemen beispielsweise bei Katalysatoren zur selektiven katalytischen Reduktion (englisch: selective catalytic reduction, abgekürzt: SCR), sogenannten SCR-Katalysatoren eingesetzt werden. Solche Katalysatoren werden eingesetzt, um die Stickoxydemission von Fahrzeugmotoren, Feuerungsanlagen, Müllverbrennungsanlagen, Industrieanlagen und dergleichen zu vermindern. Hierzu wird ein Reduktionsmittel in das Abgassystem eingedüst. Als Reduktionsmittel dient Ammoniak oder eine Ammoniaklösung oder ein anderes Reduktionsmittel. Da das Mitführen von Ammoniak in Fahrzeugen sicherheitskritisch ist, wird Harnstoff in wässriger Lösung mit üblicherweise 32,5% Harnstoffanteil insbesondere gemäß DIN 70070 eingesetzt. Im Abgas zersetzt sich der Harnstoff bei Temperaturen oberhalb von 150° Celsius in gasförmiges Ammoniak und CO₂. Parameter für die Zersetzung des Harnstoffes sind im Wesentlichen Zeit (Verdampfungs- und Reaktionszeit), Temperatur und Tröpfchengröße der eingedüsten Harnstofflösung. In diesen SCR-Katalysatoren wird durch selektive katalytische Reduktion der Ausstoß von Stickoxyden um etwa 90 % reduziert.

Von dem Stand der Technik ausgehend ist es die Aufgabe der Erfindung, ein Verfahren der eingangs genannten Art zu verbessern und insbesondere derart weiterzubilden, dass eine verlässliche Überwachung des Betriebs einer Magnetkolbenpumpe ermöglicht wird, wobei der Rechenaufwand für die Ermittlung der zur Überwachung der Magnetkolbenpumpe erforderlichen Daten reduziert werden soll.

Diese Aufgabe wird erfindungsgemäß durch ein Verfahren gemäß Anspruch 1 gelöst. Vorteilhafte Weiterbildungen der Erfindung sind in den abhängigen Ansprüchen angegeben.

Besonders vorteilhaft bei einem Verfahren zur Überwachung des Betriebs einer Magnetkolbenpumpe, bei der ein Kolben eine elektromagnetisch angetriebene Hubbewegung mit einem Bewegungsbeginn und einem Bewegungsende ausführt, wobei die Hubbewegung von einem an dem Kolben angeordneten Magnetanker mittels eines elektromagnetischen Felds veranlasst wird, das von einer Bestromung zumindest einer Spule mit einem Spulenstrom erzeugt wird, wobei die Bestromung einen Einschaltzeitpunkt und einen Ausschaltzeitpunkt aufweist, ist es, dass der Bewegungsbeginn und/oder das Bewegungsende der Hubbewegung mittels der Schritte bestimmt wird:
- Messung und Erfassung des realen Spulenstroms;
- Berechnung und Erfassung einer Differenz zwischen einem hinterlegten Spulenstrom und dem realen Spulenstrom beginnend mit dem Einschaltzeitpunkt der Bestromung über einen festgelegten Zeitraum;
- Auswertung dieser Differenz zur Bestimmung des Bewegungsbeginns und/oder des Bewegungsendes der elektromagnetisch angetriebenen Hubbewegung.

Dieser hinterlegte Spulenstrom kann abhängig von den Umgebungsparametern Spannung und/oder Einschaltdauer und/oder PWM und/oder Widerstand und/oder Induktivität entsprechend neu berechnet werden. Dabei kann der hinterlegte Spulenstrom zur Laufzeit berechnet und adaptiert werden.

Mit dem Begriff elektromagnetisch angetriebene Hubbewegung ist dabei eine einzelne Hubbewegung zwischen dem unteren Totpunkt (uT) und dem oberen Totpunkt (oT) des Kolbens der Magnetkolbenpumpe gemeint. Damit ist eine Hubbewegung des Kolbens während eines Saughubs oder während eines Förderhubs gemeint. Der Saughub beschreibt die Bewegung des Kolbens vom oberen Totpunkt, bei dem der Kolben auf Anschlag gefahren ist und somit der für das Medium verfügbare Kolbenraum gegen Null geht, zum unteren Totpunkt, bei dem der maximale Kolbenraum für das angesaugte Medium bereitgestellt wird. Mit dem Begriff Förderhub ist die umgekehrte Bewegung des Kolbens vom unteren Totpunkt zum oberen Totpunkt gemeint, wobei das Medium aus dem Kolbenraum über die Druckleitung gefördert wird. Als Kolbenraum ist der Hubraum einer Magnetkolbenpumpe definiert, der zum Ansaugen und Fördern des Mediums dient. Der Kolbenraum wird von einem Zylinder bereitgestellt. Das erfindungsgemäße Verfahren kann sowohl bei Magnetkolbenpumpe mit einem Zylinder als auch mit mehreren Zylindern angewendet werden, wobei innerhalb eines jeden Zylinders jeweils ein Kolben verfahrbar ist und erfindungsgemäß überwacht werden kann. Bei dem zu dosierenden Medium handelt es sich um ein Fluid.

Bei einer Magnetkolbenpumpe ist die zumindest eine Spule derart positioniert, dass der Magnetanker innerhalb des von der Spule erzeugten elektromagnetischen Feldes liegt, sodass der mit dem Magnetanker kinematisch gekoppelte Kolben aufgrund der auf den Magnetanker von dem elektromagnetischen Feld ausgeübten magnetischen Kraft im Zylinder verfahren wird. Insbesondere ist es möglich, mehrere Spulen anzuordnen, die das elektromagnetische Feld gemeinsam oder abwechselnd erzeugen können.

Als Bewegungsbeginn und Bewegungsende werden die jeweiligen Zeitpunkte des Bewegungsbeginns und des Bewegungsendes des Kolbens während eines einzelnen Hubs verstanden. Im erfindungsgemäßen Sinne basiert somit die Überwachung des Betriebs der Magnetkolbenpumpe auf der Ermittlung des Bewegungsbeginns und/oder des Bewegungsendes des Kolbens, aus denen sich auf die Hubbewegung und den Betrieb der Magnetkolbenpumpe schließen lässt.

Der Spulenstrom bei einer Magnetkolbenpumpe wird periodisch ein- und ausgeschaltet. Das heißt die Bestromung wird stets wiederholt, wobei eine einzelne Bestromung für einen einzelnen Hub einen Einschaltzeitpunkt und einen Ausschaltzeitpunkt aufweist. Die Zeit während einer einzelnen Bestromung, also zwischen einem Einschaltzeitpunkt und einem Ausschaltzeitpunkt wird als Ansteuerzyklus bezeichnet. Während eines Ansteuerzyklus findet jeweils ein Kolbenhub bzw. eine einzelne Hubbewegung statt. Die Gegenhubbewegung kann insbesondere mechanisch beispielsweise mittels einer Feder veranlasst werden.

Bei dem Betrieb einer derartigen Magnetkolbenpumpe können sich Gasblasen innerhalb des zu fördernden Fluids bilden, die den Betrieb stören und Einfluss auf die Fördermenge nehmen. Infolgedessen kann die Dosiermenge eines einzelnen Hubs abweichen. Ferner kann es beim Betrieb einer Magnetkolbenpumpe vorkommen, dass der Magnetanker klemmt oder lediglich einen Teilhub anstelle eines ganzen Hubs ausführt. Ein Teilhub kann dabei insbesondere auf einen zu hohen Gegendruck innerhalb der Magnetkolbenpumpe oder der Dosierleitung zurückzuführen sein.

Die beschriebenen Fehler können anhand des erfindungsgemäßen Verfahrens zur Überwachung des Betriebs einer Magnetkolbenpumpe durch eine Auswertung der Hubbewegung insofern festgestellt werden, da infolge von möglichen Fehlern wie Gasblasen und/oder eines Klemmens des Magnetankers und/oder der Ausführung eines Teilhubs die Zeitpunkte des Bewegungsbeginns und/oder des Bewegungsendes von den Zeitpunkten abweichen, die bei einem fehlerfreien Betrieb auftreten. Um jedoch eine derartige Überwachung der Hubbewegung zu ermöglichen, ist eine möglichst genaue und zuverlässige Ermittlung des Bewegungsbeginns und insbesondere des Bewegungsendes der Hubbewegung erforderlich.

Mittels des erfindungsgemäßen Verfahrens können mögliche Betriebsfehler und Defekte frühzeitig erkannt werden. Ausschlaggebend für eine derartige Überwachung ist eine möglichst genaue Bestimmung des Bewegungsbeginns und/oder des Bewegungsendes der Hubbewegung. Auf Basis dieser Daten können mögliche Fehler unmittelbar oder mittelbar über die Bestimmung weiterer Daten, beispielsweise der Laufzeit oder der Kolbengeschwindigkeit der Hubbewegung, festgestellt werden.

Erfindungsgemäß erfolgt die Bestimmung des Bewegungsbeginns und/oder des Bewegungsendes mittels folgender Schritte. Der reale Spulenstrom wird in zeitdiskreten Schritten gemessen und erfasst. Insbesondere kann der reale Spulenstrom bei einer pulsweitenmodulierten Steuerung des Stroms mehrmals, beispielsweise zwei Mal während eines einzelnen PWM-Pulses gemessen werden, im Falle dass die Ansteuerung der Bestromung der Spule pulsweitenmoduliert erfolgt.

Es erfolgt eine Berechnung und Erfassung einer Differenz zwischen einem hinterlegten Spulenstrom und dem realen Spulenstrom beginnend mit dem Einschaltzeitpunkt der Bestromung über einen festgelegten Zeitraum. Das heißt, dass die Berechnung und Erfassung mit dem Einschaltzeitpunkt eines einzelnen Ansteuerzyklus beginnt. Dabei erfolgt die Berechnung und Erfassung in zeitlicher Folge chronologisch fortschreitend. Insbesondere bei der Bestimmung des Bewegungsendes kann es jedoch vorteilhaft sein, die Berechnung der Differenz zeitlich rückschreitend durchzuführen, wobei die Differenz vom späteren Zeitpunkt aus hin zum früheren Zeitpunkt berechnet und erfasst wird, um auf diese Weise Rechenaufwand zu reduzieren.

Der hinterlegte Spulenstrom kann dabei insbesondere in zeitdiskreten Schritten, die den Schritten des gemessenen realen Spulenstroms entsprechen, in einer Wertetabelle hinterlegt sein oder mittels eines Algorithmus berechnet werden. Der hinterlegte (oder berechnete) Spulenstrom ist abhängig von Induktivität, Ohmscher Widerstand (Spule, Zuleitung, Schalttransistoren), aktueller Betriebsspannung sowie dem aktuellen Tastverhältnis. Die Induktivität wiederum ist abhängig von der Position des Kolbens (unterer Totpunkt, oberer Totpunkt) sowie dem aktuellen Spulenstrom.

Der festgelegte Zeitraum kann insbesondere der Zeit vom Einschaltzeitpunkt bis zum Ausschaltzeitpunkt der Bestromung entsprechen, wobei der festgelegte Zeitraum alternativ auch verkürzt oder verlängert werden kann.

Abschließend erfolgt eine Auswertung der Differenz zur Bestimmung des Bewegungsbeginns und/oder des Bewegungsendes der Hubbewegung. Dabei erfolgt die Auswertung des Differenzverlaufs derart, dass bei sich wiederholenden Hubbewegungen eine zuverlässige und reproduzierbare Bestimmung des Bewegungsbeginns und/oder des Bewegungsendes der Hubbewegung erfolgen kann. Dadurch wird der Einfluss, der von einem Rauschen in der Strommessung und/oder von in Steuergeräten möglicherweise vorhandenen Offsets verursacht werden kann, möglichst gering gehalten. Dabei kann der Verlauf der Differenz insbesondere anhand von Grenzwerten und/oder Extremwerten und/oder Nullstellen ausgewertet werden.

Insbesondere kann die erfindungsgemäße Überwachung dabei während jedes einzelnen Ansteuerzyklus erfolgen oder sich auf ausgewählte Ansteuerzyklen beschränken. Die daraus ermittelten Daten können insbesondere abgespeichert und/oder in Echtzeit verarbeitet werden und ggf. zur Auslösung einer Fehlermeldung herangezogen werden. Insbesondere kann jede n-te Hubbewegung überwacht werden, wobei n ≥ 1 ist. Beispielsweise kann jede hundertste Hubbewegung überwacht werden. N ist beliebig festlegbar und oder bei Feststellung eines Fehlers änderbar, sodass bei Auftreten und Feststellen eines Fehlers von einer getakteten Überwachung zu einer ständigen Überwachung gewechselt werden kann. Insbesondere kann eine Hubbewegung in festgelegten Zeitabständen nach Beginn des Betriebs der Magnetkolbenpumpe überwacht werden. Ferner wird der Rechenaufwand klein gehalten.

Durch das erfindungsgemäße Verfahren lassen sich der Bewegungsbeginn und/oder das Bewegungsende der Hubbewegung zuverlässig bestimmen. Dabei wird der Effekt ausgenutzt, dass die Bewegung des Magnetankers sowie seine Position innerhalb der Pumpe bzw. des Zylinders gegenüber der Spule den Stromaufbau und/oder den Stromabbau in der Spule verzögert und sich somit die zu berechnende Differenz zwischen dem hinterlegten Spulenstrom und dem realen Spulenstrom ergibt. Das Verfahren ist robust gegenüber Ungenauigkeiten in der Strommessung, die insbesondere von einem Rauschen in der Strommessung und/oder von in Steuergeräten vorhandenen Offsets verursacht werden können. Offsets können bei jeglichen elektronischen Bauteilen entstehen und eine fehlerfreie Messung der Werte behindern. Mittels des Verfahrens wird die Gefahr reduziert, dass einzelne mögliche Messfehler das Ergebnis der Überwachung in hohem Maße verfälschen. Ebenso ist das Verfahren robust gegenüber Serientoleranzen in Bezug auf Induktivität und Spulenwiderstand des Aktuators.

Wenn insbesondere der bestimmte Zeitpunkt des Bewegungsbeginns von einem hinterlegten Sollwert abweicht, kann im Falle eines früheren bestimmten Zeitpunktes des Bewegungsbeginns auf Gasblasen innerhalb des zu fördernden Fluids oder auf eine verschlissene Feder, welche die Gegenhubbewegung veranlasst, geschlossen werden. Dies ist der Fall, da Gas im Gegensatz zu einer Flüssigkeit kompressibel ist. Im Falle eines späteren bestimmten Zeitpunktes des Bewegungsbeginns kann insbesondere auf ein Blockieren des Magnetankers geschlossen werden.

Wenn insbesondere der bestimmte Zeitpunkt des Bewegungsendes von einem hinterlegten Sollwert abweicht, kann im Falle eines früheren bestimmten Zeitpunktes des Bewegungsendes auf eine Ausführung lediglich eines Teilhubes statt eines ganzen Hubes und/oder auf Gasblasen innerhalb des zu fördernden Fluids geschlossen werden. Im Falle eines späteren bestimmten Zeitpunktes des Bewegungsendes kann insbesondere auf ein Blockieren des Magnetankers geschlossen werden.

Vorzugsweise werden aus der Bestimmung des Bewegungsbeginns und des Bewegungsendes der Hubbewegung die Laufzeit und/oder die mittlere Geschwindigkeit der Hubbewegung berechnet. Dadurch können die beim Betrieb einer Magnetkolbenpumpe möglich auftretenden Fehler besonders einfach identifiziert werden. Die Laufzeit ist dabei die Zeit zwischen dem bestimmten Bewegungsbeginn und dem bestimmten Bewegungsende der Hubbewegung. Die mittlere Geschwindigkeit wird dabei als Quotient von dem Hubkolbenweg zwischen dem unteren und den oberen Totpunkt durch die Laufzeit verstanden. Der Rechenaufwand wird dabei klein gehalten, da keine Momentangeschwindigkeit der Hubbewegung, sondern eine mittlere Geschwindigkeit der Hubbewegung berechnet wird.

Beispielsweise kann im Falle einer Blasenbildung innerhalb des zu fördernden Fluids oder im Falle einer Ausführung eines Teilhubs die Laufzeit der Hubbewegung einen Sollwert unterschreiten, während die mittlere Geschwindigkeit der Hubbewegung einen Sollwert überschreiten kann. Im Falle eines Klemmens des Magnetankers hingegen kann die Laufzeit der Hubbewegung einen Sollwert überschreiten, während die mittlere Geschwindigkeit der Hubbewegung einen Sollwert unterschreiten kann. Die Berechnung der Laufzeit und/oder der mittleren Geschwindigkeit der Hubbewegung ermöglicht eine einfache Art und Weise der Überwachung.

Erfindungsgemäß wird der Bewegungsbeginn der Hubbewegung mittels der Schritte bestimmt:
- Berechnung und Erfassung einer Differenz zur Ermittlung des Bewegungsbeginns zwischen einem ersten hinterlegten Spulenstrom und dem realen Spulenstrom beginnend mit dem Einschaltzeitpunkt der Bestromung über einen festgelegten Zeitraum;
- Ermittlung eines ersten Zeitpunktes bei Erreichen eines ersten festgelegten Grenzwertes der Differenz zur Ermittlung des Bewegungsbeginns;
- Ermittlung eines zweiten Zeitpunktes bei Erreichen eines zweiten festgelegten Grenzwertes der Differenz zur Ermittlung des Bewegungsbeginns;
- Extrapolation der Geraden durch den ersten ermittelten Zeitpunkt und den ersten festgelegten Grenzwert der Differenz zur Ermittlung des Bewegungsbeginns sowie durch den zweiten ermittelten Zeitpunkt und den zweiten festgelegten Grenzwert der Differenz zur Ermittlung des Bewegungsbeginns bis zum Nullpunkt der Differenz zur Ermittlung des Bewegungsbeginns;
- Berechnung des Zeitpunktes beim extrapolierten Nullpunkt der Differenz zur Ermittlung des Bewegungsbeginns und Festlegung dieses Zeitpunktes als Bewegungsbeginn der Hubbewegung.

Es erfolgt eine Berechnung und Erfassung einer Differenz zur Ermittlung des Bewegungsbeginns zwischen einem ersten hinterlegten Spulenstrom und dem realen Spulenstrom beginnend mit dem Einschaltzeitpunkt der Bestromung für einen festgelegten Zeitraum. Das heißt, dass die Berechnung mit dem Einschaltzeitpunkt eines einzelnen Ansteuerzyklus beginnt.

Der erste hinterlegte Spulenstrom ist dabei abhängig von der Anfangsposition des Kolbens bzw. des Magnetankers und kann insbesondere in zeitdiskreten Schritten, die den Schritten des gemessenen realen Spulenstroms entsprechen, in einer Wertetabelle hinterlegt sein oder mittels eines Algorithmus berechnet werden. Insbesondere kann der Algorithmus dabei insbesondere die Bestromung und die Induktivität der Spule abhängig von der Anfangsposition des Magnetankers berücksichtigen. Der festgelegte Zeitraum kann insbesondere die Zeit vom Einschaltzeitpunkt bis zum Ausschaltzeitpunkt der Bestromung betragen, wobei der festgelegte Zeitraum insbesondere verkürzt oder verlängert werden kann.

Der erste hinterlegte Spulenstrom kann dabei insbesondere anhand der Bestromung, des PWM und der Induktivität der Spule abhängig von der Anfangsposition des Magnetankers berechnet werden. Der erste hinterlegte Spulenstrom ist abhängig von Induktivität, Ohmscher Widerstand (Spule, Zuleitung, Schalttransistoren), aktueller Betriebsspannung sowie dem aktuellen Tastverhältnis. Die Induktivität wiederum ist abhängig von der Position des Kolbens (unterer Totpunkt, oberer Totpunkt) sowie dem aktuellen Spulenstrom.

Es erfolgt eine Ermittlung eines ersten Zeitpunktes bei Erreichen eines ersten festgelegten Grenzwertes der Differenz zur Ermittlung des Bewegungsbeginns. Danach erfolgt eine Ermittlung eines zweiten Zeitpunktes bei Erreichen einer zweiten festgelegten Differenz zur Ermittlung des Bewegungsbeginns. Der erste festgelegte Grenzwert der Differenz zur Ermittlung des Bewegungsbeginns und/oder der zweite festgelegte Grenzwert der Differenz zur Ermittlung des Bewegungsbeginns können insbesondere als anteilig zu einem Extremwert der Differenz zur Ermittlung des Bewegungsbeginns bestimmt werden oder hinterlegte Werte annehmen. Damit ergeben sich zwei Datenpunkte, wobei sich der erste Datenpunkt aus dem ersten Zeitpunkt und dem ersten festgelegten Grenzwert der Differenz zur Ermittlung des Bewegungsbeginns ergibt und der zweite Datenpunkt sich aus dem zweiten Zeitpunkt und dem zweiten festgelegten Grenzwert der Differenz zur Ermittlung des Bewegungsbeginns ergibt.

Es erfolgt eine Extrapolation der Geraden durch diese beiden Datenpunkte. Der Schnittpunkt dieser Geraden mit der Nulllinie der Differenz wird berechnet und als Zeitpunkt des Bewegungsbeginns interpretiert.

Dadurch lässt sich der Bewegungsbeginn der Hubbewegung zuverlässig bestimmen. Ferner wird der Rechenaufwand dabei klein gehalten. Es wird der Effekt ausgenutzt, dass die Bewegung des Magnetankers sowie seine Position innerhalb der Pumpe den Stromaufbau und/oder den Stromabbau in der Spule verzögert und sich somit die zu berechnende Differenz zwischen dem ersten hinterlegten Spulenstrom und dem realen Spulenstrom ergibt. Das Verfahren ist robust gegenüber Ungenauigkeiten, die insbesondere von einem Rauschen in der Strommessung und/oder von in Steuergeräten vorhandenen Offsets verursacht werden, da der Bewegungsbeginn mittels einer Extrapolation durch zwei Datenpunke ermittelt wird. Zusätzlich kann das Stromsignal bei Bedarf gemittelt und/oder gefiltert werden. Auf diese Weise wird die Wahrscheinlichkeit reduziert, dass einzelne mögliche Messfehler, das Ergebnis der Ermittlung in hohem Maße verfälschen. Ferner ist der zu ermittelnde Bewegungsbeginn mittels des erfindungsgemäßen Verfahrens nicht in starkem Maße abhängig von der Genauigkeit der Strommessung. Somit können vorkommende Betriebsfehler auf eine zuverlässige Weise identifiziert werden. Ferner wird der Rechenaufwand für die Ermittlung des Bewegungsbeginns klein gehalten, da keine komplizierten Formeln, insbesondere Ableitungen des Stromverlaufs, berechnet werden müssen, sondern eine einfache Extrapolation zwischen zwei Datenpunkten stattfindet.

Vorzugsweise wird die Berechnung und/oder die Auswertung der Differenz zur Ermittlung des Bewegungsbeginns nach der Festlegung des Zeitpunktes des Bewegungsbeginns beendet. Unter der Berechnung und/oder der Auswertung der Differenz zur Ermittlung des Bewegungsbeginns sind die Schritte zur Bestimmung des Bewegungsbeginns gemeint. Auf diese Weise kann der Rechenaufwand des Verfahrens weiter reduziert werden. Die Schritte bzw. das Verfahren können sodann während des nächsten Ansteuerzyklus oder während des nächsten ausgewählten Ansteuerzyklus angewendet werden.

Vorzugsweise wird das Bewegungsende der Hubbewegung mittels der Schritte bestimmt:
- Berechnung und Erfassung der Differenz zur Ermittlung des Bewegungsendes zwischen einem zweiten hinterlegten Spulenstrom und dem realen Spulenstrom beginnend mit dem Einschaltzeitpunkt der Bestromung;
- Ermittlung des ersten Extremwertes des berechneten Verlaufes der Differenz;
- Ermittlung eines dritten Zeitpunktes bei Erreichen eines dritten festgelegten Grenzwertes der Differenz zur Ermittlung des Bewegungsendes chronologisch nach dem ersten Extremwert;
- Ermittlung eines vierten Zeitpunktes bei Erreichen eines vierten festgelegten Grenzwertes der Differenz zur Ermittlung des Bewegungsendes chronologisch nach dem ersten Extremwert;
- Extrapolation der Geraden durch den dritten ermittelten Zeitpunkt und den dritten festgelegten Grenzwert der Differenz zur Ermittlung des Bewegungsendes sowie durch den vierten ermittelten Zeitpunkt und den vierten festgelegten Grenzwert der Differenz zur Ermittlung des Bewegungsendes bis zu einer festgelegten Abweichung der extrapolierten Gerade von der Differenz zur Ermittlung des Bewegungsendes und Berechnung des Zeitpunktes bei Erreichen der festgelegten Abweichung und
- Festlegung dieses Zeitpunktes als Bewegungsende der Hubbewegung.

Der zweite hinterlegte Spulenstrom ist dabei abhängig von der Endposition des Kolbens bzw. des Magnetankers und kann insbesondere in zeitdiskreten Schritten, die den Schritten des gemessenen realen Spulenstroms entsprechen, in einer Wertetabelle hinterlegt sein oder mittels eines Algorithmus berechnet werden.

Somit handelt es sich bei dem zweiten hinterlegten Spulenstrom um einen anderen hinterlegten Spulenstrom als bei dem ersten hinterlegten Spulenstrom, da er von der Endposition des Magnetankers abhängig ist, während der erste hinterlegte Spulenstrom abhängig von der Anfangsposition des Magnetankers ist.

Insbesondere kann der zweite hinterlegte Spulenstrom dabei die Bestromung und die Induktivität der Spule abhängig von der Endposition des Magnetankers berücksichtigen. Der zweite hinterlegte Spulenstrom ist abhängig von Induktivität, Ohmscher Widerstand (Spule, Zuleitung, Schalttransistoren), aktueller Betriebsspannung sowie dem aktuellen Tastverhältnis. Die Induktivität wiederum ist abhängig von der Position des Kolbens (unterer Totpunkt, oberer Totpunkt) sowie dem aktuellen Spulenstrom.

Chronologisch nach dem ersten ermittelten Extremwert der Differenz werden dabei zwei Datenpunkte in Form des dritten festgelegten Grenzwertes der Differenz und des dritten Zeitpunktes sowie des vierten festgelegten Grenzwertes und des vierten Zeitpunktes ermittelt.

Durch diese beiden Datenpunkte wird eine Gerade bestimmt. Sodann wird derjenige Zeitpunkt berechnet, bei welchem die so bestimmte Gerade eine festgelegte Abweichung von der Differenz zur Ermittlung des Bewegungsendes aufweist. Dieser Zeitpunkt wird als Bewegungsende festgelegt.

Der festgelegte Zeitraum kann insbesondere die Zeit vom Einschaltzeitpunkt bis zum Ausschaltzeitpunkt betragen, wobei der festgelegte Zeitraum alternativ auch verkürzt oder verlängert werden kann.

Vorzugsweise wird das Bewegungsende der Hubbewegung mittels der Schritte bestimmt:
- Berechnung und Erfassung einer Differenz zur Ermittlung des Bewegungsendes zwischen einem zweiten hinterlegten Spulenstrom und dem realen Spulenstrom beginnend mit dem Einschaltzeitpunkt der Bestromung;
- Berechnung der Extremwerte der Differenz zur Ermittlung des Bewegungsendes beginnend mit dem Einschaltzeitpunkt der Bestromung;
- Berechnung des Gradienten der Differenz zur Ermittlung des Bewegungsendes chronologisch nach dem letzten ermittelten Extremwert;
- Berechnung des Zeitpunktes, bei dem der Gradient einen festgelegten Grenzwert erreicht;
- Festlegung dieses Zeitpunktes als Bewegungsende der Hubbewegung.

Die vorhergehende Erläuterung in Bezug auf den zweiten hinterlegten Spulenstrom gilt hierbei entsprechend.

Vorzugsweise wird das Bewegungsende der Hubbewegung mittels der Schritte bestimmt:
- Berechnung und Erfassung einer Differenz zur Ermittlung des Bewegungsendes zwischen einem zweiten hinterlegten Spulenstrom und dem realen Spulenstrom beginnend mit dem Einschaltzeitpunkt der Bestromung;
- Berechnung des Gradienten der Differenz zur Ermittlung des Bewegungsendes beginnend mit dem Ausschaltzeitpunkt des Spulenstroms;
- umgekehrt chronologische Auswertung des berechneten Gradienten beginnend mit dem Ausschaltzeitpunkt des Spulenstroms;
- Berechnung des Zeitpunktes beim ersten ermittelten Extremwert und Festlegung dieses Zeitpunktes als Bewegungsende der Hubbewegung.

Die vorhergehende Erläuterung in Bezug auf den zweiten hinterlegten Spulenstrom gilt hierbei entsprechend.

Die Berechnung des Gradienten der Differenz zur Ermittlung des Bewegungsendes beginnend mit dem Ausschaltzeitpunkt des Spulenstroms kann dabei insbesondere zeitlich fortschreitend als auch zeitlich rückschreitend erfolgen. Dies ist der Fall, da dies für die Ermittlung des ersten Extremwertes unerheblich ist.

Der Begriff der umgekehrt chronologischen Auswertung des berechneten Gradienten beginnend mit dem Ausschaltzeitpunkt des Spulenstroms bedeutet, dass die Auswertung des berechneten Gradienten mit dem Ausschaltzeitpunkt des Spulenstroms startet und in zeitlicher Folge rückschreitend stattfindet. Bei einer graphischen Betrachtung des berechneten Differenzverlaufs würde dies bedeuten, dass die Auswertung der die Zeitachse bildende Abszisse zeitlich von rechts nach links erfolgt. Dies verschafft einen weiteren Vorteil bei der Reduktion des Rechenaufwands, da das Bewegungsende, welches üblicherweise zeitlich näher an dem Ausschaltzeitpunkt des Spulenstroms liegt als am Einschaltzeitpunkt der Bestromung, beim ersten ermittelten Extremwert festgelegt wird.

Somit handelt es sich hierbei beim ersten ermittelten Extremwert, um den Extremwert, der bei einer zeitlich fortschreitender Betrachtung als letzter Extremwert bezeichnet werden würde.

Vorzugsweise wird eins der beschriebenen Verfahren zur Bestimmung des Bewegungsendes der Hubbewegung genutzt.

Vorzugsweise werden die Berechnung und/oder die Auswertung der Differenz zur Festlegung des Bewegungsendes nach der Ermittlung des Bewegungsendes beendet. Unter der Berechnung und/oder der Auswertung der Differenz zur Ermittlung des Bewegungsendes sind die Schritte zur Bestimmung des Bewegungsendes gemeint. Auf diese Weise kann der Rechenaufwand des Verfahrens weiter reduziert werden. Die Schritte bzw. das Verfahren können sodann während des nächsten Ansteuerzyklus oder während des nächsten ausgewählten Ansteuerzyklus angewendet werden.

Vorzugsweise wird der hinterlegte Spulenstrom, insbesondere werden der erste und/oder der zweite hinterlegte Spulenstrom abhängig von der Induktivität der Spule adaptiert. Anders ausgedrückt werden der erste hinterlegte Spulenstrom und/oder der zweite hinterlegte Spulenstrom abhängig von der Induktivität der Spule insbesondere mittels Korrekturfaktoren angepasst. Mit der Induktivität der Spule ist die Spule in Verbindung mit dem Magnetanker insbesondere abhängig von der Position des Magnetankers gemeint. Hierdurch können sich aufgrund der Umgebungsbedingungen ändernde Parameter berücksichtigt werden.

Insbesondere kann der erste hinterlegte Spulenstrom derart adaptiert werden, dass vor dem Bewegungsbeginn die Differenz zur Ermittlung des Bewegungsbeginns gegen Null läuft.

Vorzugsweise wird der hinterlegte Spulenstrom, insbesondere werden der erste und/oder der zweite hinterlegte Spulenstrom abhängig von Induktivität und Widerstand der Spule bzw. des gesamten Stromkreises (Spule, Zuleitung, Steuergerät) adaptiert. Anders ausgedrückt werden der erste hinterlegte Spulenstrom und/oder der zweite hinterlegte Spulenstrom abhängig von dem Widerstand des die Spule einschließenden Stromkreises mittels Korrekturfaktoren angepasst. Der Stromkreis umfasst dabei neben der Spule die Zuleitungen zu der Spule sowie das Steuergerät. Der Widerstand der Spule ist abhängig von der Temperatur der Spule. Insbesondere kann deshalb die Temperatur der Spule mittels der in der durchgeführten Adaption verwendeten Korrektur bestimmt werden. Folglich ist es jedoch auch umgekehrt möglich, die Temperatur der Spule zu messen und den ersten hinterlegten Spulenstrom und/oder den zweiten hinterlegten Spulenstrom vorzugsweise abhängig von dem gemessenen Temperaturwert zu adaptieren. Basierend auf einer derart adaptierten Bewegungszeiterkennung werden die vorherrschenden Parameter dem Prozess nachgeführt, sodass eine stabile bzw. konstante Fördermenge auch mit sich ändernden Umgebungsbedingungen möglich ist.

Insbesondere kann der erste hinterlegte Spulenstrom derart adaptiert werden, dass die Differenz zur Ermittlung des Bewegungsbeginns und/oder die Differenz zur Ermittlung des Bewegungsendes gegen den Ausschaltzeitpunkt, insbesondere während oder nach dem Ausschaltzeitpunkt der Bestromung gegen Null läuft.

Dadurch wird eine Anpassung des hinterlegten Spulenstroms, insbesondere des ersten und/oder des zweiten hinterlegten Spulenstroms an die Umgebungsbedingungen, insbesondere Temperatur und/oder Induktivität der Spule in Verbindung mit dem Magnetanker ermöglicht.

Insbesondere kann der erste hinterlegte Spulenstrom und/oder der zweite hinterlegte Spulenstrom abhängig von einer gemessenen Temperatur der Spule adaptiert werden.

Vorzugsweise werden basierend auf einer adaptierten Bewegungszeiterkennung die Parameter des Betriebs der Magnetkolbenpumpe dem Prozess nachgeführt, sodass eine konstante Fördermenge auch bei sich ändernden Umgebungsbedingungen gefördert wird.

Vorzugsweise erfolgt eine Regelung der Bestromung der Spule insbesondere pulsweitenmoduliert in Abhängigkeit einer ermittelten Kolbenlaufzeit und/oder in Abhängigkeit einer ermittelten mittleren Kolbengeschwindigkeit und/oder in Abhängigkeit des Widerstands des die Spule einschließenden Stromkreises. Der Stromkreis umfasst dabei neben der Spule die Zuleitungen zu der Spule sowie das Steuergerät. Die Regelung erfolgt dabei innerhalb eines geschlossenen Regelkreises. Insbesondere kann die Bestromung der Spule pulsweitenmoduliert erfolgen.

Alternativ oder kumulativ kann die Regelung der Bestromung der Spule auch abhängig von den mittels des Verfahrens bestimmten Zeitpunkten des Bewegungsbeginns und/oder des Bewegungsendes erfolgen, insbesondere in Abhängigkeit einer Abweichung zwischen den bestimmten Zeitpunkten des Bewegungsbeginns und/oder des Bewegungsendes und den hinterlegten Zeitpunkten des Bewegungsbeginns und/oder des Bewegungsendes. Durch eine derartige Regelung können mögliche Dosiermengenschwankungen der Magnetkolbenpumpe reduziert werden. Somit kann die Dosiermenge pro Hub auf einem konstanten Niveau gehalten werden.

Insbesondere kann die Regelung der Bestromung der Spule alternativ oder kumulativ abhängig von der Temperatur der Spule erfolgen. Die Regelung erfolgt dabei innerhalb eines geschlossenen Regelkreises.

Ein Ausführungsbeispiel der Erfindung ist in den Figuren dargestellt und wird nachfolgend erläutert. Es zeigen:
- Fig. 1a: die schematische Ansicht einer Magnetkolbenpumpe bei einem ersten Betriebszustand;
- Fig. 1b: die schematische Ansicht einer Magnetkolbenpumpe bei einem zweiten Betriebszustand;
- Fig. 2: den Verlauf der Differenz zwischen einem ersten hinterlegten Spulenstrom und dem realen Spulenstrom und eine Auswertemethode zur Ermittlung des Bewegungsbeginns anhand dieses Verlaufs;
- Fig. 3: den Verlauf der der Differenz zwischen einem zweiten hinterlegten Spulenstrom und dem realen Spulenstrom und eine erste Auswertemethode zur Ermittlung des Bewegungsendes anhand dieses Verlaufs;
- Fig. 4: den Verlauf der der Differenz zwischen einem zweiten hinterlegten Spulenstrom und dem realen Spulenstrom und eine zweite Auswertemethode zur Ermittlung des Bewegungsendes anhand dieses Verlaufs;
- Fig. 5: den Verlauf der der Differenz zwischen einem zweiten hinterlegten Spulenstrom und dem realen Spulenstrom und eine dritte Auswertemethode zur Ermittlung des Bewegungsendes anhand dieses Verlaufs.

Die Figurendarstellungen sind schematisch und nicht maßstabsgerecht. Die Zahlenwerte sind beispielhaft zu verstehen.

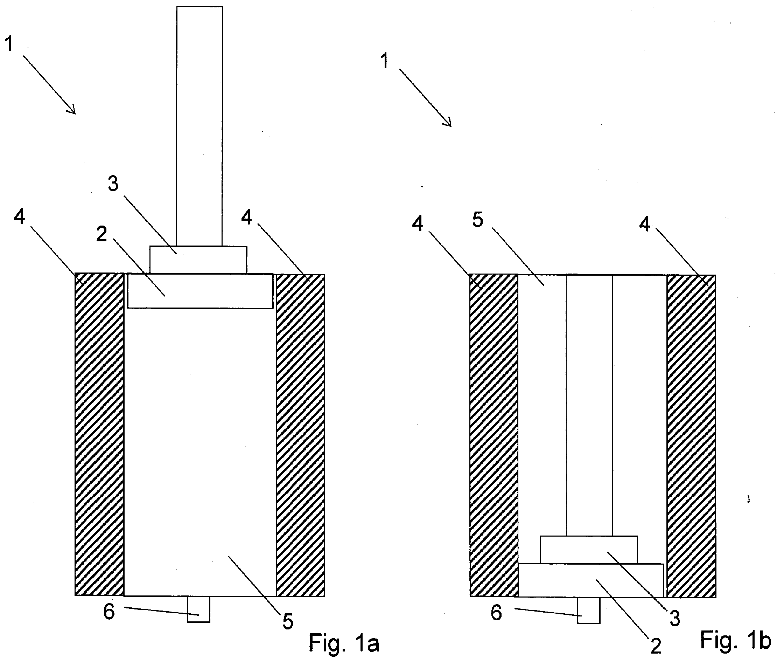

Die Figuren 1a und 1b zeigen schematisch eine Magnetkolbenpumpe 1 in zwei unterschiedlichen Betriebszuständen. Die Magnetkolbenpumpe weist eine um einen Zylinder 5 gewickelte Spule 4, einen Kolben 2, einen Magnetanker 3 und einen Auslass 6 auf. In Figur 1a befindet sich der Kolben 2 am unteren Totpunkt und stellt somit den größten Kolbenraum des Zylinders 5 für das zu fördernde Fluid dar. Der Zylinder 5 ist dabei mit dem zu fördernden Fluid gefüllt. Wenn nun die Spule bestromt wird, wird mittels der Spule 4 ein elektromagnetisches Feld erzeugt, das den Magnetanker 3 zusammen mit dem Kolben 2 veranlasst, eine Hubbewegung auszuführen und währenddessen das zu fördernde Fluid durch den Auslass 6 zu fördern. Der Zustand gemäß Figur 1a zeigt somit den Kolben vor bzw. während eines Zeitpunktes des Bewegungsbeginns der Hubbewegung.

In Figur 1b befindet sich der Kolben 2 am oberen Totpunkt. Das zu fördernde Fluid wurde dabei im idealen Fall gänzlich aus dem Zylinder 5 über den Auslass 6 gefördert. Der Zustand gemäß Figur 1b zeigt somit den Kolben nach bzw. während eines Zeitpunktes des Bewegungsendes der Hubbewegung.

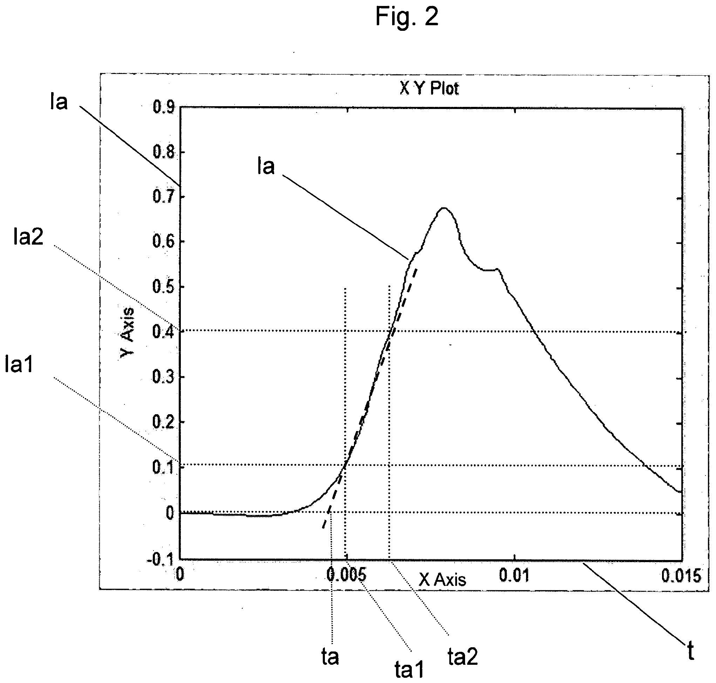

Die Figur 2 zeigt den Verlauf der Differenz la zur Ermittlung des Bewegungsbeginns ta zwischen einem ersten hinterlegten Spulenstrom und dem realen Spulenstrom in einem Diagramm. Auf der X-Achse ist die Zeit t in Sekunden und auf der Y-Achse ist die Differenz la zur Ermittlung des Bewegungsbeginns ta zwischen einem ersten hinterlegten Spulenstrom und dem realen Spulenstrom in Ampere aufgetragen.

Erfasst und abgebildet ist hierbei der Verlauf der Differenz la zur Ermittlung des Bewegungsbeginns ta zwischen einem ersten hinterlegten Spulenstrom und dem realen Spulenstrom beginnend mit dem Einschaltzeitpunkt der Bestromung über den festgelegten Zeitraum von 0 bis 0,015 Sekunden. Der festgelegte Zeitraum entspricht hierbei einem einzelnen Ansteuerzyklus, der 0,015 Sekunden beträgt. Das heißt, dass die Bestromungsdauer der Spule zur Ausführung einer einzelnen Hubbewegung 0,015 Sekunden beträgt. Die Bestromung beginnt bei 0 Sekunden und endet somit bei 0,015 Sekunden entsprechend dem Diagramm gemäß Fig. 2.

Der erste hinterlegte Spulenstrom ist dabei abhängig von der Anfangsposition und ist in zeitdiskreten Schritten, die der Abtastung und damit den Schritten des gemessenen realen Spulenstroms entsprechen, in einer Wertetabelle hinterlegt.

Der erste hinterlegte Spulenstrom ist dabei anhand der Bestromung und der Induktivität der Spule abhängig von der Anfangsposition des Magnetankers berechnet. Der erste hinterlegte Spulenstrom ist abhängig von Induktivität, Ohmscher Widerstand (Spule, Zuleitung, Schalttransistoren), aktueller Betriebsspannung sowie dem aktuellen Tastverhältnis. Die Induktivität wiederum ist abhängig von der Position des Kolbens (unterer Totpunkt, oberer Totpunkt) sowie dem aktuellen Spulenstrom. Der erste hinterlegte Spulenstrom wird in diesem Ausführungsbeispiel abhängig von der Induktivität der Spule adaptiert. Dabei wird ein Korrekturfaktor eingesetzt, wodurch die Differenz zur Ermittlung des Bewegungsbeginns la unmittelbar nach dem Beginn der Aufzeichnung, aber vor dem Bewegungsbeginn auf Null kalibriert wird.

Es erfolgt eine Ermittlung eines ersten Zeitpunktes ta1 bei Erreichen eines ersten festgelegten Grenzwerts la1 der Differenz la zur Ermittlung des Zeitpunktes des Bewegungsbeginns ta. Danach erfolgt eine Ermittlung eines zweiten Zeitpunktes ta2 bei Erreichen eines zweiten festgelegten Grenzwerts la2 der Differenz la zur Ermittlung des Bewegungsbeginns ta. Der erste festgelegte Grenzwert la1 der Differenz la zur Ermittlung des Bewegungsbeginns ta und der zweite festgelegte Grenzwert la2 der Differenz la zur Ermittlung des Bewegungsbeginns ta nehmen hinterlegte Werte an.

Damit ergeben sich zwei Datenpunkte, wobei sich der erste Datenpunkt aus dem ersten Zeitpunkt ta1 und dem ersten festgelegten Grenzwert la1 der Differenz la zur Ermittlung des Bewegungsbeginns ta ergibt und der zweite Datenpunkt sich aus dem zweiten Zeitpunkt ta2 und der zweiten festgelegten Grenzwert la2 der Differenz la zur Ermittlung des Bewegungsbeginns ta ergibt.

Es erfolgt eine Extrapolation der Geraden durch diese beiden Datenpunkte zum Nullpunkt der Differenz la zur Ermittlung des Bewegungsbeginns ta. Anders ausgedrückt wird eine durch die beiden Datenpunkte festgelegte Gerade bestimmt, die durch den Nullpunkt des Verlaufs der Differenz la zur Ermittlung des Bewegungsbeginns ta führt.

Abschließend erfolgt eine Berechnung des Zeitpunktes ta beim extrapolierten Nullpunkt der Differenz la zur Ermittlung des Bewegungsbeginns ta und Festlegung dieses Zeitpunktes als Bewegungsbeginn ta der Hubbewegung.

Dadurch lässt sich der Bewegungsbeginn ta der Hubbewegung zuverlässig bestimmen. Ferner wird der Rechenaufwand dabei klein gehalten, da keine komplizierten Formeln, insbesondere Ableitungen des Stromverlaufs, berechnet werden müssen, sondern eine einfache Extrapolation zwischen zwei Datenpunkten stattfindet.

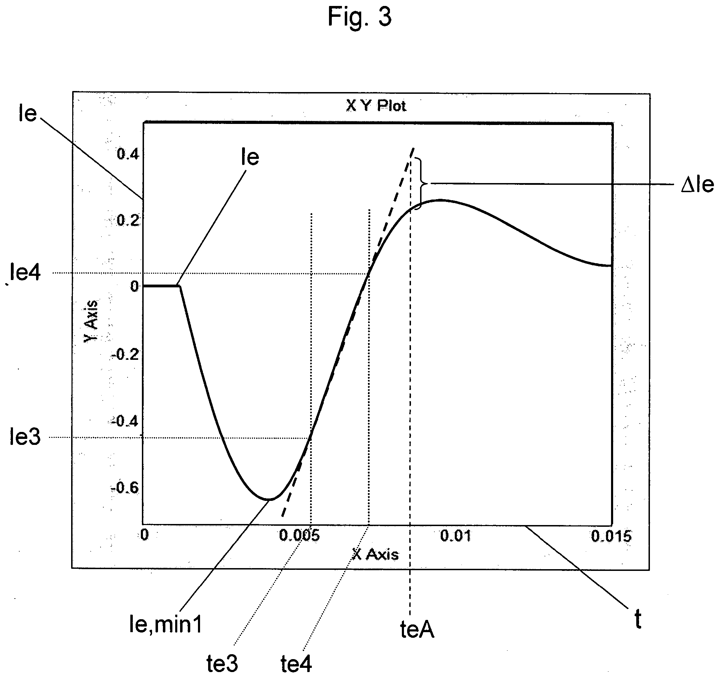

Die Figuren 3 bis 5 zeigen jeweils den Verlauf der der Differenz le zur Ermittlung des Zeitpunktes des Bewegungsendes teA, teB, teC zwischen einem zweiten hinterlegten Spulenstrom und dem realen Spulenstrom in einem Diagramm. Auf der X-Achse ist die Zeit t in Sekunden und auf der Y-Achse ist die Differenz le zur Ermittlung des Bewegungsendes teA, teB, teC zwischen einem zweiten hinterlegten Spulenstrom und dem realen Spulenstrom in Ampere aufgetragen.

Erfasst und abgebildet in den Figuren 3 bis 5 ist jeweils der Verlauf der Differenz zur Ermittlung des Bewegungsendes le zwischen einem zweiten hinterlegten Spulenstrom und dem realen Spulenstrom beginnend mit dem Einschaltzeitpunkt der Bestromung über den festgelegten Zeitraum von 0 bis 0,015 Sekunden. Der festgelegte Zeitraum entspricht hierbei einem einzelnen Ansteuerzyklus, der 0,015 Sekunden beträgt. Das heißt, dass die Bestromungsdauer der Spule zur Ausführung einer einzelnen Hubbewegung 0,015 Sekunden beträgt. Die Bestromung beginnt bei 0 Sekunden und endet somit bei 0,015 Sekunden entsprechend dem Diagramm.

Der zweite hinterlegte Spulenstrom ist dabei abhängig von der Endposition und ist in zeitdiskreten Schritten, die der Abtastung und damit den Schritten des gemessenen realen Spulenstroms entsprechen, in einer Wertetabelle hinterlegt.

Der zweite hinterlegte Spulenstrom ist dabei anhand der Bestromung und der Induktivität der Spule abhängig von der Endposition des Magnetankers berechnet. Der zweite hinterlegte Spulenstrom ist abhängig von Induktivität, Ohmscher Widerstand (Spule, Zuleitung, Schalttransistoren), aktueller Betriebsspannung sowie dem aktuellen Tastverhältnis. Die Induktivität wiederum ist abhängig von der Position des Kolbens (unterer Totpunkt, oberer Totpunkt) sowie dem aktuellen Spulenstrom.

In den Figuren 3 bis 5 ist jeweils der Verlauf der der Differenz zwischen dem zweiten hinterlegten Spulenstrom und dem realen Spulenstrom abgebildet. Anhand der Figuren 3 bis 5 werden nachfolgend drei alternative Auswertemethoden zur Ermittlung des Bewegungsendes anhand dieses Verlaufs der Differenz erläutert. Diese drei Auswertemethoden können auch kumulativ angewandt werden. Allen drei Auswertemethoden ist gemein, dass in einem ersten Schritt die Berechnung und Erfassung der Differenz le zur Ermittlung des Bewegungsendes teA, teB, teC zwischen einem zweiten hinterlegten Spulenstrom und dem realen Spulenstrom erfolgt.

Nach der Berechnung und Erfassung der Differenz le zur Ermittlung des Bewegungsendes teA zwischen einem zweiten hinterlegten Spulenstrom und dem realen Spulenstrom erfolgt gemäß der Figur 3 eine Ermittlung des ersten Extremwertes le,min1, welcher in diesem Fall ein Minimum ist. Ferner erfolgt eine Ermittlung eines dritten Zeitpunktes te3 bei Erreichen eines dritten festgelegten Grenzwertes le3 der Differenz le zur Ermittlung des Bewegungsendes teA chronologisch nach dem ersten Extremwert le,min1. Ferner erfolgt eine Ermittlung eines vierten Zeitpunktes te4 bei Erreichen eines vierten festgelegten Grenzwertes le4 der Differenz le zur Ermittlung des Bewegungsendes teA chronologisch nach dem ersten Extremwert le,min1.

Es erfolgt eine Extrapolation der Geraden durch den dritten ermittelten Zeitpunkt te3 und den dritten festgelegten Grenzwert le3 der Differenz le zur Ermittlung des Bewegungsendes teA sowie durch den vierten ermittelten Zeitpunkt te4 und den vierten festgelegten Grenzwert le4 der Differenz le zur Ermittlung des Bewegungsendes teA bis zu einer festgelegten Abweichung Δle der extrapolierten Gerade von der Differenz le zur Ermittlung des Bewegungsendes teA und Berechnung des Zeitpunktes teA bei Erreichen der festgelegten Abweichung Δle. Dieser Zeitpunkt wird gemäß der ersten Auswertemethode als Bewegungsende teA der Hubbewegung festgelegt.

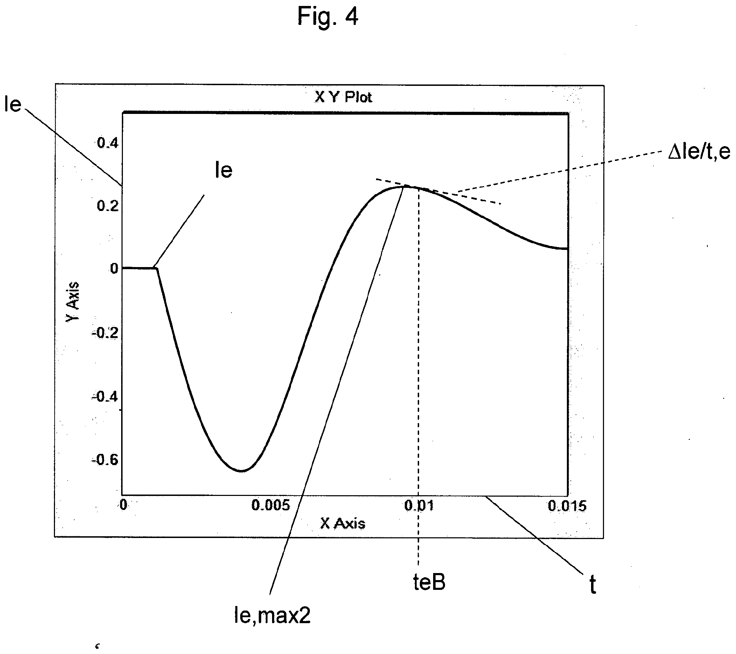

Bei der zweiten Auswertemethode gemäß Figur 4 erfolgt nach der Berechnung und Erfassung der Differenz le zur Ermittlung des Bewegungsendes teB zwischen einem zweiten hinterlegten Spulenstrom und dem realen Spulenstrom eine Berechnung der Extremwerte der Differenz le zur Ermittlung des Bewegungsendes teB.

Chronologisch nach dem letzten ermittelten Extremwert le,max2, der in diesem Fall ein Maximum ist, erfolgt eine Berechnung des Gradienten der Differenz le zur Ermittlung des Bewegungsendes teB. Anschließend erfolgt eine Berechnung des Zeitpunktes teB, bei dem der Gradient einen festgelegten Grenzwert Δle/t,e erreicht. Abschließend wird dieser Zeitpunkt teB als Bewegungsende teB der Hubbewegung festgelegt.

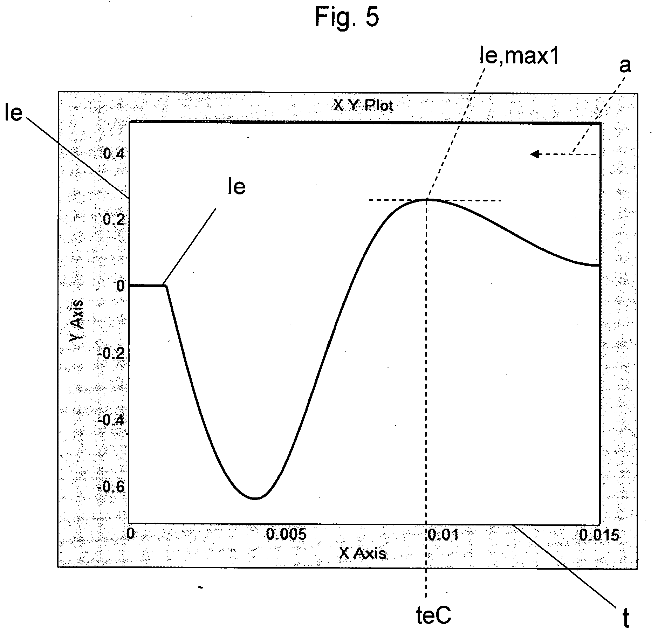

Bei der dritten Auswertemethode gemäß Figur 5 erfolgt nach der Berechnung und Erfassung der Differenz zur Ermittlung des Bewegungsendes le zwischen einem zweiten hinterlegten Spulenstrom und dem realen Spulenstrom eine Berechnung des Gradienten der Differenz zur Ermittlung des Bewegungsendes teC beginnend mit dem Ausschaltzeitpunkt des Spulenstroms. Ferner erfolgt eine umgekehrt chronologische Auswertung des berechneten Gradienten beginnend mit dem Ausschaltzeitpunkt des Spulenstroms gemäß Pfeil a.

Abschließend erfolgt eine Berechnung des Zeitpunktes teC beim ersten ermittelten Extremwert le,max1, der in diesem Fall ein Maximum ist, und Festlegung dieses Zeitpunktes teC als Bewegungsende teC der Hubbewegung.

Jeder einzelne der auf diese Weise ermittelbaren Zeitpunkte des Bewegungsendes teA, teB, teC kann für sich alleine oder durch Mittelwertbildung mit einem weiteren Wert für den Zeitpunkt des Bewegungsendes für weitere Auswertungen wie beispielsweise die Ermittlung der Kolbenlaufzeit herangezogen werden. Hierdurch ist eine Betriebsüberwachung der Kolbenpumpe realisierbar.

### Bezugszeichenliste

- 1: Magnetkolbenpumpe
- 2: Magnetkolben
- 3: Magnetanker
- 4: Spule
- 5: Zylinder
- 6: Auslass
- ta: Bewegungsbeginn
- teA, teB, teC: Bewegungsende nach jeweiliger Auswertemethode
- la: Differenz zur Ermittlung des Bewegungsbeginns zwischen dem ersten hinterlegten Spulenstrom und dem realen Spulenstrom
- le: Differenz zur Ermittlung des Bewegungsendes zwischen einem zweiten hinterlegten Spulenstrom und dem realen Spulenstrom
- la1: erster festgelegter Grenzwert der Differenz zur Ermittlung des Bewegungsbeginns
- la2: zweiter festgelegter Grenzwert der Differenz zur Ermittlung des Bewegungsbeginns
- ta1: erster ermittelter Zeitpunkt
- ta2: zweiter ermittelter Zeitpunkt
- le3: dritter festgelegter Grenzwert der Differenz zur Ermittlung des Bewegungsendes
- le4: vierter festgelegter Grenzwert der Differenz zur Ermittlung des Bewegungsendes
- te3: dritter ermittelter Zeitpunkt
- te4: vierter ermittelter Zeitpunkt
- le,min1: erster Extremwert
- Δle: festgelegte Abweichung der extrapolierten Gerade von der Differenz zur Ermittlung des Bewegungsendes
- le,max2: letzter ermittelter Extremwert
- Δle/t,e: festgelegter Grenzwert des Gradienten
- le,max1: erster Extremwert bei der umgekehrt chronologischen Auswertung
- a: Auswertungsrichtung

## Patentansprüche

1. Verfahren zur Überwachung des Betriebs einer Magnetkolbenpumpe (1), bei der ein Kolben (2) eine elektromagnetisch angetriebene Hubbewegung mit einem Bewegungsbeginn und einem Bewegungsende ausführt, wobei die Hubbewegung von einem an dem Kolben (2) angeordneten Magnetanker (3) mittels eines elektromagnetischen Felds veranlasst wird, das von einer Bestromung zumindest einer Spule (4) mit einem Spulenstrom erzeugt wird, wobei die Bestromung einen Einschaltzeitpunkt und einen Ausschaltzeitpunkt aufweist, wobei der Bewegungsbeginn (ta) und/oder das Bewegungsende (teA, teB, teC) der Hubbewegung mittels der Schritte bestimmt wird:
- Messung und Erfassung des realen Spulenstroms;
- Berechnung und Erfassung einer Differenz (la; le) zwischen einem hinterlegten Spulenstrom und dem realen Spulenstrom beginnend mit dem Einschaltzeitpunkt der Bestromung über einen festgelegten Zeitraum;
- Auswertung dieser Differenz zur Bestimmung des Bewegungsbeginns (ta) und/oder des Bewegungsendes (teA, teB, teC) der elektromagnetisch angetriebenen Hubbewegung, **dadurch gekennzeichnet, dass** der Bewegungsbeginn (ta) der Hubbewegung mittels der Schritte bestimmt wird:
- Berechnung und Erfassung einer Differenz (la) zur Ermittlung des Bewegungsbeginns (ta) zwischen einem ersten hinterlegten Spulenstrom und dem realen Spulenstrom beginnend mit dem Einschaltzeitpunkt der Bestromung über einen festgelegten Zeitraum;
- Ermittlung eines ersten Zeitpunktes (ta1) bei Erreichen eines ersten festgelegten Grenzwertes (la1) der Differenz (la) zur Ermittlung des Bewegungsbeginns (ta);
- Ermittlung eines zweiten Zeitpunktes (ta2) bei Erreichen eines zweiten festgelegten Grenzwertes (la2) der Differenz (la) zur Ermittlung des Bewegungsbeginns (ta);
- Extrapolation der Geraden durch den ersten ermittelten Zeitpunkt (ta1) und den ersten festgelegten Grenzwert (la1) der Differenz (la) zur Ermittlung des Bewegungsbeginns (ta) sowie durch den zweiten ermittelten Zeitpunkt (ta2) und den zweiten festgelegten Grenzwert (la2) der Differenz (la) zur Ermittlung des Bewegungsbeginns (ta) bis zum Nullpunkt der Differenz (la) zur Ermittlung des Bewegungsbeginns (ta);
- Berechnung des Zeitpunktes (ta) beim extrapolierten Nullpunkt der Differenz (la) zur Ermittlung des Bewegungsbeginns und Festlegung dieses Zeitpunktes als Bewegungsbeginn (ta) der Hubbewegung.

2. Verfahren nach Anspruch 1, **dadurch gekennzeichnet, dass** aus der Bestimmung des Bewegungsbeginns (ta) und des Bewegungsendes (teA, teB, teC) der Hubbewegung die Laufzeit und/oder die mittlere Geschwindigkeit der Hubbewegung berechnet werden.

3. Verfahren nach einem der vorherigen Ansprüche, **dadurch gekennzeichnet, dass** die Berechnung und/oder die Auswertung der Differenz (la) zur Ermittlung des Bewegungsbeginns (ta) nach der Festlegung des Zeitpunktes des Bewegungsbeginns (ta) beendet werden.

4. Verfahren nach einem der vorherigen Ansprüche, **dadurch gekennzeichnet, dass** das Bewegungsende (teA) der Hubbewegung mittels der Schritte bestimmt wird:
- Berechnung und Erfassung der Differenz (le) zur Ermittlung des Bewegungsendes (teA) zwischen einem zweiten hinterlegten Spulenstrom und dem realen Spulenstrom beginnend mit dem Einschaltzeitpunkt der Bestromung;
- Ermittlung des ersten Extremwertes (le,min1) des berechneten Verlaufes der Differenz (le);
- Ermittlung eines dritten Zeitpunktes (te3) bei Erreichen eines dritten festgelegten Grenzwertes (le3) der Differenz (le) zur Ermittlung des Bewegungsendes (teA) chronologisch nach dem ersten Extremwert (le,min1);
- Ermittlung eines vierten Zeitpunktes (te4) bei Erreichen eines vierten festgelegten Grenzwertes (le4) der Differenz (le) zur Ermittlung des Bewegungsendes (teA) chronologisch nach dem ersten Extremwert (le,min1);
- Extrapolation der Geraden durch den dritten ermittelten Zeitpunkt (te3) und den dritten festgelegten Grenzwert (le3) der Differenz (le) zur Ermittlung des Bewegungsendes (teA) sowie durch den vierten ermittelten Zeitpunkt (te4) und den vierten festgelegten Grenzwert (le4) der Differenz (le) zur Ermittlung des Bewegungsendes (teA) bis zu einer festgelegten Abweichung (Δle) der extrapolierten Gerade von der Differenz (le) zur Ermittlung des Bewegungsendes (teA) und Berechnung des Zeitpunktes (teA) bei Erreichen der festgelegten Abweichung (Δle) und
- Festlegung dieses Zeitpunktes als Bewegungsende (teA) der Hubbewegung.

5. Verfahren nach einem der vorherigen Ansprüche, **dadurch gekennzeichnet, dass** das Bewegungsende (teB) der Hubbewegung mittels der Schritte bestimmt wird:
- Berechnung und Erfassung einer Differenz (le) zur Ermittlung des Bewegungsendes (teB) zwischen einem zweiten hinterlegten Spulenstrom und dem realen Spulenstrom beginnend mit dem Einschaltzeitpunkt der Bestromung;
- Berechnung der Extremwerte der Differenz (le) zur Ermittlung des Bewegungsendes (teB) beginnend mit dem Einschaltzeitpunkt der Bestromung;
- Berechnung des Gradienten der Differenz (le) zur Ermittlung des Bewegungsendes chronologisch nach dem letzten ermittelten Extremwert (le,max2);
- Berechnung des Zeitpunktes, bei dem der Gradient einen festgelegten Grenzwert (Δle/t,e) erreicht;
- Festlegung dieses Zeitpunktes als Bewegungsende (teB) der Hubbewegung.

6. Verfahren nach einem der vorherigen Ansprüche, **dadurch gekennzeichnet, dass** das Bewegungsende (teC) der Hubbewegung mittels der Schritte bestimmt wird:
- Berechnung und Erfassung einer Differenz (le) zur Ermittlung des Bewegungsendes (teC) zwischen einem zweiten hinterlegten Spulenstrom und dem realen Spulenstrom beginnend mit dem Einschaltzeitpunkt der Bestromung;
- Berechnung des Gradienten der Differenz (le) zur Ermittlung des Bewegungsendes (teC) beginnend mit dem Ausschaltzeitpunkt des Spulenstroms;
- umgekehrt chronologische Auswertung des berechneten Gradienten beginnend mit dem Ausschaltzeitpunkt des Spulenstroms;
- Berechnung des Zeitpunktes beim ersten ermittelten Extremwert (le,max1) und Festlegung dieses Zeitpunktes als Bewegungsende (teC) der Hubbewegung.

7. Verfahren nach einem der Ansprüche 4 bis 6, **dadurch gekennzeichnet, dass** die Berechnung und/oder die Auswertung der Differenz (le) zur Ermittlung des Bewegungsendes (teA, teB, teC) nach der Festlegung des Bewegungsendes (teA, teB, teC) beendet wird.

8. Verfahren nach einem der vorherigen Ansprüche, **dadurch gekennzeichnet, dass** der hinterlegte Spulenstrom, insbesondere der erste und/oder der zweite hinterlegte Spulenstrom abhängig von der Induktivität der Spule (4) adaptiert wird/werden.

9. Verfahren nach einem der vorherigen Ansprüche, **dadurch gekennzeichnet, dass** der der hinterlegte Spulenstrom, insbesondere der erste und/oder der zweite hinterlegte Spulenstrom abhängig von dem Widerstand des Stromkreises insbesondere umfassend die Spule (4) und/oder eine Zuleitung und/oder ein Steuergerät adaptiert wird/werden.

10. Verfahren nach einem der vorherigen Ansprüche, **dadurch gekennzeichnet, dass** der erste hinterlegte Spulenstrom und/oder der zweite hinterlegte Spulenstrom abhängig von einer gemessenen Temperatur der Spule (4) adaptiert wird/werden.

11. Verfahren nach einem der vorherigen Ansprüche, **dadurch gekennzeichnet, dass** basierend auf einer adaptierten Bewegungszeiterkennung die Parameter des Betriebs der Magnetkolbenpumpe (1) dem Prozess nachgeführt werden, sodass eine konstante Fördermenge auch bei sich ändernden Umgebungsbedingungen gefördert wird.

12. Verfahren nach einem der vorherigen Ansprüche, **dadurch gekennzeichnet, dass** eine Regelung der Bestromung der Spule (4) insbesondere pulsweitenmoduliert in Abhängigkeit einer ermittelten Kolbenlaufzeit und/oder in Abhängigkeit einer ermittelten mittleren Kolbengeschwindigkeit und/oder in Abhängigkeit des Widerstands des Stromkreises insbesondere umfassend die Spule (4) und/oder eine Zuleitung und/oder ein Steuergerät erfolgt.

## Claims

1. Method for monitoring the operation of a magnetic piston pump (1), in which a piston (2) executes an electromagnetically driven stroke movement with a movement start and a movement end, wherein the stroke movement is caused by a magnet armature (3) arranged on the piston (2) by means of an electromagnetic field, which is generated by energisation of at least one coil (4) with a coil current, wherein the energisation has a switch-on timepoint and a switch-off timepoint, wherein the movement start (ta) and/or the movement end (teA, teB, teC) of the stroke movement is determined by means of the steps:
- measurement and detection of the actual coil current;
- calculation and detection of a difference (la; le) between a stored coil current and the actual coil current starting with the switch-on timepoint of the energisation over a defined period of time;
- evaluation of this difference for determination of the movement start (ta) and/or the movement end (teA, teB, teC) of the electromagnetically driven stroke movement, **characterized in that** the movement start (ta) of the stroke movement is determined by means of the steps:
- calculation and detection of a difference (la) for identification of the movement start (ta) between a first stored coil current and the actual coil current starting with the switch-on timepoint of the energisation over a defined period of time;
- identification of a first timepoint (ta1) when a first defined limit value (la1) of the difference (la) is reached for identification of the movement start (ta);
- identification of a second timepoint (ta2) when a second defined limit value (la2) of the difference (la) is reached for identification of the movement start (ta);
- extrapolation of the straight line through the first identified timepoint (ta1) and the first defined limit value (la1) of the difference (la) for identification of the movement start (ta) as well as through the second identified timepoint (ta2) and the second defined limit value (la2) of the difference (la) for identification of the movement start (ta) up to the zero point of the difference (la) for identification of the movement start (ta);
- calculation of the timepoint (ta) at the extrapolated zero point of the difference (la) for identification of the movement start and definition of this timepoint as the movement start (ta) of the stroke movement.

2. Method according to claim 1, **characterised in that** the running time and/or the average speed of the stroke movement are calculated from the determination of the movement start (ta) and the movement end (teA, teB, teC) of the stroke movement.

3. Method according to any one of the preceding claims, **characterised in that** the calculation and/or the evaluation of the difference (la) for identification of the movement start (ta) are terminated after the definition of the timepoint of the movement start (ta).

4. Method according to any one of the preceding claims, **characterised in that** the movement end (teA) of the stroke movement is determined by means of the steps:
- calculation and detection of the difference (le) for identification of the movement end (teA) between a second stored coil current and the actual coil current starting with the switch-on timepoint of the energisation;
- identification of the first extreme value (le,min1) of the calculated course of the difference (le);
- identification of a third timepoint (te3) when a third defined limit value (le3) of the difference (le) is reached for identification of the movement end (teA) chronologically after the first extreme value (le,min1);
- identification of a fourth timepoint (te4) when a fourth defined limit value (le4) of the difference (le) for identification of the movement end (teA) is reached chronologically after the first extreme value (le,min1);
- extrapolation of the straight line through the third identified timepoint (te3) and the third defined limit value (le3) of the difference (le) for identification of the movement end (teA) as well as through the fourth identified timepoint (te4) and the fourth defined limit value (le4) of the difference (le) for identification of the movement end (teA) up to a defined deviation (Δle) of the extrapolated straight line from the difference (le) for identification of the movement end (teA) and calculation of the timepoint (teA) when the defined deviation (Δle) is reached, and
- definition of this timepoint as the movement end (teA) of the stroke movement.

5. Method according to any one of the preceding claims, **characterised in that** the movement end (teB) of the stroke movement is determined by means of the steps:
- calculation and detection of a difference (le) for identification of the movement end (teB) between a second stored coil current and the actual coil current starting with the switch-on timepoint of the energisation;
- calculation of the extreme values of the difference (le) for identification of the movement end (teB) starting with the switch-on timepoint of the energisation;
- calculation of the gradient of the difference (le) for identification of the movement end chronologically after the last identified extreme value (le,max2);
- calculation of the timepoint at which the gradient reaches a defined limit value (Δle/t,e);
- definition of this timepoint as the movement end (teB) of the stroke movement.

6. Method according to any one of the preceding claims, **characterised in that** the movement end (teC) of the stroke movement is determined by means of the steps:
- calculation and detection of a difference (le) for identification of the movement end (teC) between a second stored coil current and the actual coil current starting with the switch-on timepoint of the energisation;
- calculation of the gradient of the difference (le) for identification of the movement end (teC) starting with the switch-off timepoint of the coil current;
- reverse chronological evaluation of the calculated gradient starting with the switch-off timepoint of the coil current;
- calculation of the timepoint at the first identified extreme value (le,max1) and definition of this timepoint as the movement end (teC) of the stroke movement.

7. Method according to any one of the claims 4 to 6, **characterised in that** the calculation and/or the evaluation of the difference (le) for identification of the movement end (teA, teB, teC) is terminated after the definition of the movement end (teA, teB, teC).

8. Method according to any one of the preceding claims, **characterised in that** the stored coil current, in particular the first and/or the second stored coil current, is/are adapted in dependence on the inductance of the coil (4).

9. Method according to any one of the preceding claims, **characterised in that** the stored coil current, in particular the first and/or the second stored coil current, is/are adapted in dependence on the resistance of the circuit, in particular comprising the coil (4) and/or a supply line and/or a control device.

10. Method according to any one of the preceding claims, **characterised in that** the first stored coil current and/or the second stored coil current is/are adapted in dependence on a measured temperature of the coil (4).

11. Method according to any one of the preceding claims, **characterised in that**, based on an adapted movement time detection, the parameters of the operation of the magnetic piston pump (1) are fed back to the process, so that a constant delivery rate is delivered even with changing ambient conditions.

12. Method according to any one of the preceding claims, **characterised in that** the energisation of the coil (4) is regulated, in particular in a pulse-width modulated manner, in dependence on an identified piston running time and/or in dependence on an identified average piston speed and/or in dependence on the resistance of the circuit, in particular comprising the coil (4) and/or a supply line and/or a control unit.

## Revendications

1. Procédé de surveillance du fonctionnement d'une pompe à piston magnétique (1), pour lequel un piston (2) réalise un mouvement de levage entraîné de manière électromagnétique avec un début de mouvement et une fin de mouvement, dans lequel le mouvement de levage est incité par un induit magnétique (3) agencé au niveau du piston (2) au moyen d'un champ électromagnétique qui est généré par une alimentation au moins d'une bobine (4) avec un courant de bobine, dans lequel l'alimentation présente un moment de mise en service et un moment de mise hors service, dans lequel le début de mouvement (ta) et/ou la fin de mouvement (teA, teB, teC) du mouvement de levage est déterminé au moyen des étapes suivantes :
- la mesure et la détection du courant de bobine réel ;
- le calcul et la détection d'une différence (la ; le) entre un courant de bobine enregistré et le courant de bobine réel en commençant par le moment de mise en service de l'alimentation pendant une période fixée ;
- l'évaluation de cette différence pour la détermination du début de mouvement (ta) et/ou de la fin de mouvement (teA, teB, teC) du mouvement de levage entraîné de manière électromagnétique, **caractérisé en ce que** le début de mouvement (ta) du mouvement de levage est déterminé au moyen des étapes suivantes :
- le calcul et la détection d'une différence (la) pour la détermination du début de mouvement (ta) entre un premier courant de bobine enregistré et le courant de bobine réel en commençant par le moment de mise en service de l'alimentation pendant une période fixée ;
- la détermination d'un premier moment (ta1) lors de l'atteinte d'une première valeur limite fixée (la1) de la différence (la) pour la détermination du début de mouvement (ta) ;
- la détermination d'un deuxième moment (ta2) lors de l'atteinte d'une deuxième valeur limite fixée (la2) de la différence (la) pour la détermination du début de mouvement (ta) ;
- l'extrapolation des droites par le premier moment déterminé (ta1) et la première valeur limite (la1) fixée de la différence (la) pour la détermination du début de mouvement (ta) ainsi que par le deuxième moment déterminé (ta2) et la deuxième valeur limite fixée (la2) de la différence (la) pour la détermination du début de mouvement (ta) jusqu'au point zéro de la différence (la) pour la détermination du début de mouvement (ta) ;
- le calcul du moment (ta) au point zéro extrapolé de la différence (la) pour la détermination du début de mouvement et la fixation de ce moment comme début de mouvement (ta) du mouvement de levage.

2. Procédé selon la revendication 1, **caractérisé en ce que** la durée et/ou la vitesse moyenne du mouvement de levage est/sont calculée(s) à partir de la détermination du début de mouvement (ta) et de la fin de mouvement (teA, teB, teC) du mouvement de levage.

3. Procédé selon l'une quelconque des revendications précédentes, **caractérisé en ce que** le calcul et/ou l'évaluation de la différence (la) pour la détermination du début de mouvement (ta) est/sont terminé(es) après la fixation du moment du début de mouvement (ta).

4. Procédé selon l'une quelconque des revendications précédentes, **caractérisé en ce que** la fin du mouvement (teA) du mouvement de levage est déterminée au moyen des étapes suivantes :
- le calcul et la détection de la différence (le) pour la détermination de la fin de mouvement (teA) entre un second courant de bobine enregistré et le courant de bobine réel en commençant par le moment de mise en service de l'alimentation ;
- la détermination de la première valeur extrême (le,min1) de l'étendue calculée de la différence (le) ;
- la détermination d'un troisième moment (te3) lors de l'atteinte d'une troisième valeur limite fixée (le3) de la différence (le) pour la détermination de la fin de mouvement (teA) de manière chronologique selon la première valeur extrême (le,min1) ;
- la détermination d'un quatrième moment (te4) lors de l'atteinte d'une quatrième valeur limite (le4) fixée de la différence (le) pour la détermination de la fin de mouvement (teA) de manière chronologique selon la première valeur extrême (le,min1) ;
- l'extrapolation des droites par le troisième moment déterminé (te3) et la troisième valeur limite (le3) fixée de la différence (le) pour la détermination de la fin de mouvement (teA) ainsi que par le quatrième moment déterminé (te4) et la quatrième valeur limite (le4) fixée de la différence (le) pour la détermination de la fin de mouvement (teA) jusqu'à un écart fixé (Δle) de la droite extrapolée de la différence (le) pour la détermination de la fin de mouvement (teA) et le calcul du moment (teA) lors de l'atteinte de l'écart fixé (Δle) et
- la fixation de ce moment comme fin de mouvement (teA) du mouvement de levage.

5. Procédé selon l'une quelconque des revendications précédentes, **caractérisé en ce que** la fin du mouvement (teB) du mouvement de levage est déterminée au moyen des étapes suivantes :
- le calcul et la détection d'une différence (le) pour la détermination de la fin de mouvement (teB) entre un second courant de bobine enregistré et le courant de bobine réel en commençant par le moment de mise en service de l'alimentation ;
- le calcul des valeurs extrêmes de la différence (le) pour la détermination de la fin de mouvement (teB) en commençant par le moment de mise en service de l'alimentation ;
- le calcul du gradient de la différence (le) pour la détermination de la fin de mouvement de manière chronologique selon la dernière valeur extrême déterminée (le,max2) ;
- le calcul du moment auquel le gradient atteint une valeur limite (Δle/t,e) fixée ;
- la fixation de ce moment comme fin du mouvement (teB) du mouvement de levage.

6. Procédé selon l'une quelconque des revendications précédentes, **caractérisé en ce que** la fin du mouvement (teC) du mouvement de levage est déterminée au moyen des étapes suivantes :
- le calcul et la détection d'une différence (le) pour la détermination de la fin de mouvement (teC) entre un second courant de bobine enregistré et le courant de bobine réel en commençant par le moment de mise en service de l'alimentation ;
- le calcul du gradient de la différence (le) pour la détermination de la fin de mouvement (teC) en commençant par le moment de mise hors service du courant de bobine ;
- inversement l'évaluation chronologique du gradient calculé en commençant par le moment de mise hors service du courant de bobine ;
- le calcul du moment pour la première valeur extrême déterminée (le,max1) et la fixation de ce moment comme fin de mouvement (teC) du mouvement de levage.

7. Procédé selon l'une quelconque des revendications 4 à 6, **caractérisé en ce que** le calcul et/ou l'évaluation de la différence (le) pour la détermination de la fin de mouvement (teA, teB, teC) est/sont terminé(es) après la fixation de la fin de mouvement (teA, teB, teC).

8. Procédé selon l'une quelconque des revendications précédentes, **caractérisé en ce que** le courant de bobine enregistrée, en particulier le premier et/ou le second courant de bobine enregistré est/sont adapté(s) en fonction de l'inductance de la bobine (4).

9. Procédé selon l'une quelconque des revendications précédentes, **caractérisé en ce que** le courant de bobine enregistré, en particulier le premier et/ou le second courant de bobine enregistré est/sont adapté(s) en fonction de la résistance du circuit électrique en particulier comprenant la bobine (4) et/ou une conduite d'amenée et/ou un appareil de commande.

10. Procédé selon l'une quelconque des revendications précédentes, **caractérisé en ce que** le premier courant de bobine enregistré et/ou le second courant de bobine enregistré est/sont adapté(s) en fonction d'une température mesurée de la bobine (4).

11. Procédé selon l'une quelconque des revendications précédentes, **caractérisé en ce que** sur la base d'une reconnaissance de temps de mouvement adaptée les paramètres du fonctionnement de la pompe à piston magnétique (1) sont ajustés au processus de sorte qu'une quantité de refoulement constante soit aussi refoulée en cas de conditions ambiantes se modifiant.

12. Procédé selon l'une quelconque des revendications précédentes, **caractérisé en ce qu'**une régulation de l'alimentation de la bobine (4) est effectuée en particulier de manière modulée en largeur d'impulsion en fonction d'une durée de marche de piston déterminée et/ou en fonction d'une vitesse de piston médiane déterminée et/ou en fonction de la résistance du circuit électrique en particulier comprenant la bobine (4) et/ou une conduite d'amenée et/ou un appareil de commande.
